# EUROPEAN PATENT APPLICATION

(11) **EP 0 602 918 A1**
(43) Date of publication of application: **22.06.1994**
(21) Application number: 93310012.5
(22) Date of filing: 13.12.1993
(51) Int. Cl.: G03F 9/00, G03F 7/20

(54) **Method and apparatus for preparing printing plates**

(30) Priority: 14.12.1992 SE 9203760
(71) Applicant: Du Pont (UK) Limited, Leeds LS14 2AL (GB)
(72) Inventor: Stening, Gunnar, S-144 00 Rönninge (SE); Tuulse, Tanel, S-151 57 Södertälje (SE)

(57) **Abstract**

A printing plate is prepared by providing an original (13), which can be an opaque paper or plastic original, with punch holes according to a predetermined layout. The original (13) is mounted on register pins (9, 10) on an original carrier (1) and the original carrier (1) together with the original (13) is moved into a light protected exposure chamber (4). A radiation sensitive plate (14) is placed with its sensitive surface facing downwardly, in an approximate position on top of the original (13). By means of at least two pushers (30, 31, 32), the plate (14) is moved to an exact position against at least three positioning guides (9, 10, 11) of which two or more may be constituted by the register pins (9, 10) for the original (13). The plate (14) is exposed through said original (13) and then processed in a light protected processing station (5) so as to be ready for use as a printing plate in a printing machine.

## Description

The present invention relates to a method and an apparatus for preparing printing plates and, more particularly but not exclusively, is concerned with the production of printing plates by copying a negative or positive print original onto a radiation sensitive plate comprising a substrate coated with a radiation sensitive layer to form an image of the original and then processing the image so that it can directly by used for printing. The invention is, primarily, intended to be used for preparing offset lithographic printing plates, but it can also be used for preparing letter press printing plates and hybrid plates of various kinds.

When preparing a printing plate it is often important that any and all printing plates relating to one and the same printed matter are in exact, so called, register, by which is meant that the text and pictures etc., constituting the matter to be printed are positioned in exactly coinciding places on the various printing plates used. This is important when the printed matter involves only one colour and also when several colours are involved. Even when printing in one colour it is important that the printed matter e.g. text and pictures are in the same mutual positions so that they appear in exactly coinciding places on the printed pages. It is often complicated and time consuming to adjust the position of the printing plate in the printing machine, and it is therefore important that the text, pictures and coloured areas making up the printed matter are positioned in as correct a position as possible on the related printing plates. This is of special importance when making prints in several colours since each colour is printed by means of a separate printing plate, and the coloured area need to be printed in exactly the correct position. This is also of extreme importance when making screened prints since the screen colour dots have to fall in strictly determined positions in relation to previously printed screen colour dots.

Printing successive sheets in one colour and printing in multi-colour are often effected using rotary printing presses having several successive print units, or multi-colour printing machines, and in both cases it can be difficult and time consuming to adjust the positions of the printing plates so that ink is applied in exactly the correct positions.

When printing using a single colour it has so far been the practice to prepare the text parts and the picture parts separately and to glue or tape them together, according to a predetermined layout, to obtain an original in the form of a so called "paste-up" for each separate page to be printed. The paste-up is provided with register marks and is photo reproduced to provide a negative or positive transparent film, called an original film. The original film is formed with punch holes which, for each separate page, have very exactly determined positions. A radiation sensitive plate is provided with equivalent punch holes arranged according to the desired placing of text and pictures on the printing plate. The original film and the radiation sensitive plate are mounted on register pins in a copying machine by means of their coinciding punch holes, and the original film is copied onto the radiation sensitive plate which is thereafter processed, e.g. developed, fixed and made ready for use as a printing plate on the printing press. In a corresponding way, entire sets of print page plates, in exactly coinciding positions, are prepared for one and the same printed matter.

Multi-colour printing plates have generally been prepared similarly in that, usually screened, part colour separation films are made from the multi-colour original, e.g. black-yellow-magenta-cyan. The part colour separations are formed with punch holes and each part colour separation film is copied onto a radiation sensitive plate having equivalent punch holes.

Up until recently, radiation sensitive plates have had rather poor light sensitivity which has meant that intense exposure light and long exposure times have been needed. Thus, while a first plate is being exposed there has usually been sufficient time for prearranging the next film and radiation sensitive plate to be exposed, and said conventional method has not been considered to involve any serious problems and disadvantages.

Recently, however, it has been possible to provide radiation sensitive plates which have a highly sensitive layer and which can therefore be fully exposed in a much shorter time than has so far been possible. It has even been possible to expose such plates by means of a simple point light, which has not previously been possible. Also, since the exposure layer of the plate has such a high sensitivity it has even proved possible to expose the plate directly through an original in the form of a paper copy or an opaque plastic copy of an ordinary paste-up, or through a printing original prepared, for example, by means of a computer via a "printer" or a "plotter". It has also been possible to eliminate the need to prepare transparent original films of text and pictures, and thus a useful print original can be prepared very quickly and very simply. In spite of the opacity of the print original material, radiation sensitive plates are being exposed much quicker than has so far been possible.

This has led to the possibility of:-
- firstly avoiding the need to prepare transparent original films,
- secondly enabling the paper or plastic original or the plotter print to be formed directly with punch holes according to a predetermined layout, and
- thirdly, and most importantly in this connection, enabling radiation sensitive plates having no punch holes to be used for copying the original onto the printing plate.

Thus, the pre-preparation of both the radiation sentive plate and the original is substantially quicker than according to the conventional pre-preparation method, and also it is possible to make use of radiation sensitive plates which are smaller, and thereby cheaper, than has so far been possible since there is no need to use any area of the plate for the punch holes. The material of the radiation sensitive plate is expensive, and also the amount of time spent in preparing the printing plate is expensive, and therefore the suggested method involves a substantial reduction of the total costs of the final printing plate. The method makes it possible to handle both radiation sensitive plates having register punch holes and plates not having such register holes. Also the risk of register errors as a consequence of mis-positioning when making the punch holes of the plate is eliminated. In addition, the method makes it possible also to use the plates in printing presses which do not have any mounting pins corresponding to punch holes of the plates. Further there is less need for pre-preparation steps than hitherto, since any precision needed solely involves the original.

Although the invention has been developed in connection with the handling of the above mentioned "quick-exposure" radiation sensitive plates, the invention can also be used for copying and exposing conventional radiation sensitive plates using a light source which is appropriate for such conventional plates. Therefore it should be noted that the invention is not limited to any special type of radiation sensitive plate.

In a preferred form the present invention is based on the use of an original in the form of a paper copy or a plastic copy of an ordinary "paste-up", or the use of an original prepared by means of a computer via a "plotter" or a "printer". The original is formed with punch bores according to a predetermined layout and is mounted on the register pins of an original carrier. The original carrier together with the original is moved into a light protected exposure chamber. A radiation sensitive plate is let down onto the original with the radiation sensitive surface thereof facing downwards. By means of at least two pushing means the plate is moved into contact with at least three positioning guides provided angularly to each other, two or more of which positioning guides may be register pins for the original, whereby the plate is brought into exact position in relation to the original. The plate is exposed through the original to form an image and the exposed plate is processed, e.g. developed, fixed and made ready in a light protected plate treatment chamber. The printing plate is thereafter ready for being used in the printing machine.

According to one aspect of the present invention, there is provided a method of preparing a printing plate which comprises:-
(a) forming punch holes in an original;
(b) mounting the original on an original carrier having register pins by passing the pins though the punch holes;
(c) moving the original carrier together with the original into an exposure chamber;
(d) providing a radiation sensitive plate comprising a substrate coated with a radiation sensitive layer;
(e) placing the radiation sensitive plate, with the layer face down, on the original;
(f) moving the radiation sensitive plate into contact with at least three positioning guides whereby it is located in a desired predetermined position in relation to the original;
(g) exposing the radiation sensitive plate through the original; and
(h) processing the exposed plate to obtain the desired printing plate.

A further aspect of the present invention provides an apparatus for preparing a printing plate comprising:-
(a) an original carrier;
(b) a magazine for a stack of radiation sensitive plates comprising a substrate coated with a radiation sensitive layer;
(c) an exposure chamber;
(d) a means for moving the original carrier into the exposure chamber;
(e) a lifting and transporting means for lifting the uppermost plate from the stack, transporting it into the exposure chamber, and placing it, with its layer face down, on an original carried by the original carrier; and
(f) means for processing the exposed plate;

wherein the original carrier is provided with at least three angularly located register pins of which two pass through punch holes in the original so that the original is mounted on the original in a correct position and said original carrier includes at least two pushers located to push the plate over the surface of the original into a predetermined position against the register pins.

For a better understanding of the invention and to show how the same may be carried into effect, reference will now be made, by way of example, to the accompanying drawings, in which:-
Figure 1 diagrammatically shows a top view of a complete plate treatment equipment incorporating the present invention, and
Figure 2 diagrammatically shows, in four integral sub-figures, details of important parts of the equipment shown in Figure 1.

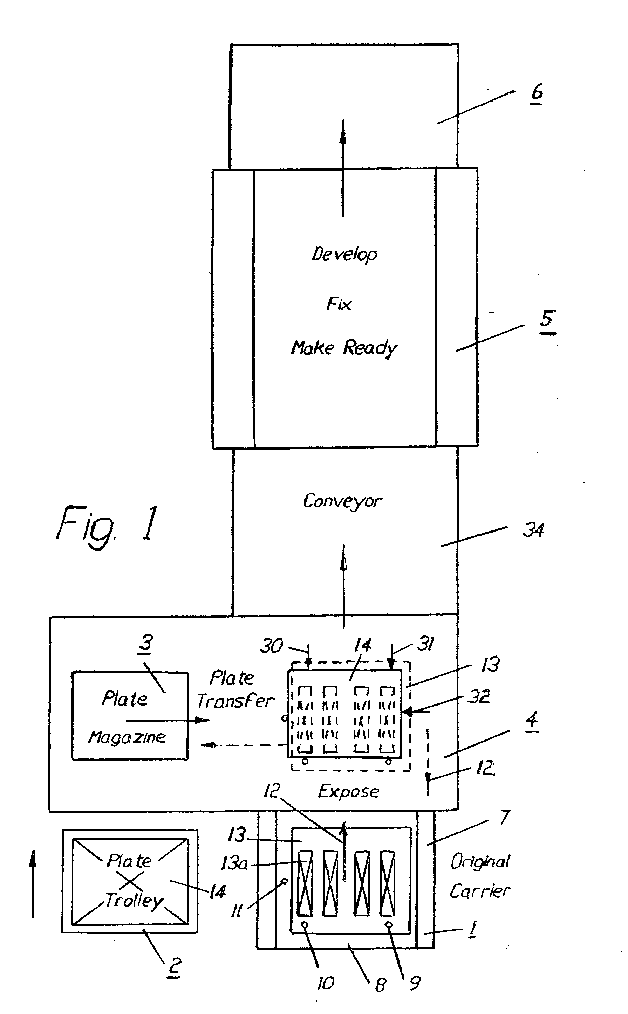

The equipment diagrammatically shown in Figure 1 generally comprises an original carrier 1, a plate trolley 2, a plate magazine 3, an exposure chamber 4, a plate processing station 5, in which the plate is, for example developed, fixed and finally treated, e.g. lacquered so as to be made ready for use as a printing plate, and a magazine 6 for ready to use printing plates.

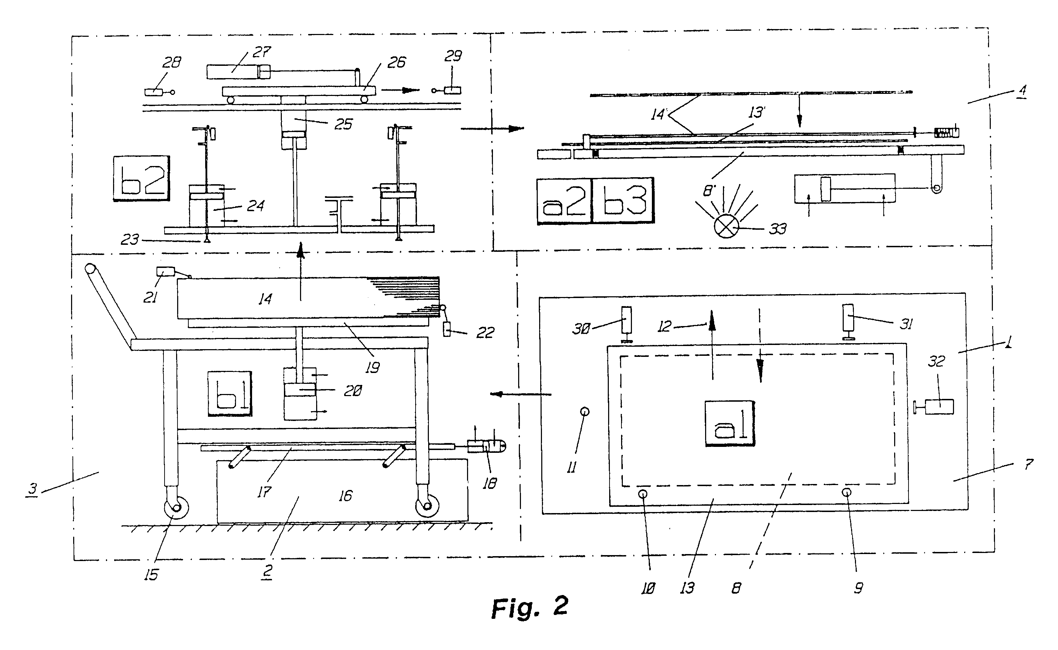

The original carrier 1 (shown in more detail as a top view in drawing al of Fig. 2) is in the form of a carriage 7 having a glass plate 8, on which at least three register pins 9, 10, 11 are fixedly mounted. The 3 register pins are angularly located so that one of the pins is positioned laterally of a straight line joining the other two pins. The original carriage 7 is movable between a daylight position outside exposure chamber 4 and an exposure position in exposure chamber 4 over guides (not illustrated) in the direction of the arrows 12. Since the exposure can be made very quickly when highly sensitive radiation sensitive plates are used in accordance with the invention, it may be advisable to provide the equipment with an additional original carriage (not shown). In this case, the original carriages are used alternately whereby a second original can be mounted on the second original carried outside the exposure chamber 4 while the first original on the first original carrier is being exposed inside the exposure chamber 4.

In Figure 1 there is shown an original 13, (which can be a print original prepared by computer in a plotter or printer or in the form of a paper or plastics copy of a paste up but which may, alternatively, be a transparent film original if such a film original is available) and which in the illustrated embodiment comprises four columns 13a, is provided with punch holes whereby it is mounted on two of the register pins 9 and 10 and hence is correctly positioned on the carrier. The third register pin 11 need not be used for the original 13, but, of course, it can be used for said original if the original is provided with a corresponding punch hole. Said third register pin 11 is however primarily, intended to be used for guiding the radiation sensitive plate into an exactly correct position in relation to the original 13. In Figure 1 the original carrier is shown by dotted lines when in its exposure position in the exposure chamber 4.

The plate trolley 2 (shown in more detail as a side view in drawing b1 of Fig. 2) is formed so that a stack of radiation sensitive plates 14, which are lying face down on the trolley, are protected from light whenever the trolley is subjected to daylight. This is necessary when handling, in the daylight, plates of the above mentioned new highly sensitive type. The plate trolley 2 is arranged so as to be moveable adjacent to the exposure chamber 4, where it constitutes a light protected plate magazine 3, from which a lifting and transporting means lifts, in a light protected position, one plate 14 at a time and moves the same into position over the original 13 on the original carrier 1 in the exposure chamber 4.

As is best evident from drawing b1 of Figure 2 the plate trolley 2 is movable on floor-engaging rolls 15, but it can be lifted up, so that said rolls are spaced from the floor, and be fixedly positioned in a desired location by carrier means 16 via a parallel linkage lifting means 17 which is actuatable by any known power means 18. The plates 14 lie on a table 19 which, by another power means 20, can be lifted to a desired elevated position, which is defined by a limit positioning switch 21 operably connected to the power means 20. Another limit position switch 22, operably connected to power means 18, defines the exact side position of the plate magazine 3. In this way, the plates 14 are placed in the correct position for subsequent transfer into the exposure chamber 4.

The lifting and transporting means for the plates (shown in more detail as a side view in drawing b2 of Figure 2) comprises several suction lifters 23 which, actuated by a power means 24, can be lowered as desired so as to be suction connected to the uppermost plate 14 of the plate magazine 3. After said plate has been suction connected, it is lifted some distance (with its radiation sensitive layer facing downwardly) by means of lifting device 25 which is mounted on a carriage 26 arranged to be displaced (together with the plate 14 attached thereto) on a guide (not illustrated) to a position above the original 13 in the exposure chamber 4. Diagrammatically illustrated pusher means 27 and limit positioning switches 28 and 29 operably connected thereto control the displacement and the positioning of the carriage 26.

When the carriage 26 has moved the plate 14 to a position above the original 13 in the exposure chamber 4, the suction lifter means 23 are de-actuated and release the plate 14. The plate 14 is then blown or laid down into an approximate position, on top of the original 13 (as shown in more detail as a side view in drawing a2b3 of Fig. 2). Three pushers 30, 31 and 32 (see drawing a1) are mounted on the original carrier 1. Pushes 30 and 31 act on that edge of the plate 14 which is opposite to the edge near pins 9 and 10 and pusher 32 acts on that edge of the plate 14 which is opposite to the edge nearer pin 11. By activating the pushers 30, 31 and 32, the plate 14 is moved into connect with the register pins 9, 10, 11 which serve as positioning guides so that the plate adopts an exactly predetermined position in relation to the original 13. After the plate 14 has been suction connected to the original 13, as known per se, the plate is subjected to exposure, which can be made by means of a simple exposure point light, as marked diagrammatically by numeral 33.

The subsequent processing of the plate is conventional, and this is effected by feeding the plate 14, by means of a light protected conveyor 34, into the light protected plate processing station 5, in which the plate is, for example, developed, fixed and treated in desired manner to obtain a plate for printing, whereupon the plate is moved out and is stacked in magazine 6 for the ready to use plates.

## Claims

1. Method of preparing a printing plate which comprises:-
(a) forming punch holes in an original (13);
(b) mounting the original on an original carrier (1) having register pins (9, 10, 11) by passing the pins though the punch holes;
(c) moving the original carrier (1) together with the original (13) into an exposure chamber (4);
(d) providing a radiation sensitive plate (14) comprising a substrate coated with a radiation sensitive layer;
(e) placing the radiation sensitive plate, with the layer face down, on the original;
(f) moving the radiation sensitive plate into contact with at least three positioning guides (9, 10, 11) whereby it is located in a desired predetermined position in relation to the original;
(g) exposing the radiation sensitive plate through the original (13); and
(h) processing the exposed plate to obtain the desired printing plate.

2. A method in accordance with claim 1 wherein the original (13) is a paper or plastics copy of a paste up or is directly prepared using a computer and the radiation sensitive layer is of high sensitivity.

3. A method according to claim 1 or 2 wherein the original (13) is provided with two punch holes according to a predetermined layout and coinciding with two of said register pins (9, 10) of the original carrier.

4. A method in accordance with claim 3 wherein two of the positioning guides are constituted by said two register pins.

5. A method according to any preceding claim wherein a first original on a first original carrier is exposed in the exposure chamber (4) whilst a second original is mounted in daylight on a second original carrier.

6. An apparatus for preparing a printing plate comprising:-
(a) an original carrier (1);
(b) a magazine (3) for a stack of radiation sensitive plates (14) comprising a substrate coated with a radiation sensitive layer;
(c) an exposure chamber (4);
(d) a means for moving the original carrier into the exposure chamber (4);
(e) a lifting and transporting means for lifting the uppermost plate from the stack, transporting it into the exposure chamber (4), and placing it, with its layer face down, on an original (13) carried by the original carrier (1); and
(f) means (5) for processing the exposed plate;
wherein the original carrier (1) is provided with at least three angularly located register pins (9, 10, 11) of which two (9, 10) pass through punch holes in the original so that the original is mounted on the original in a correct position and said original carrier (1) includes at least two pushers (30, 31, 32) located to push the plate over the surface of the original into a predetermined position against the register pins (9, 10, 11).

7. Apparatus as claimed in claim 6, and further including a plate trolley (2) for supporting the stack of radiation sensitive plates (14) in light protected condition, the plate trolley (2) being moveable into a correct position (22) in a light protected magazine (3) provided with means (16, 18) for lifting and for locking the plate trolley in a predetermined position, and the trolley being provided with means (19, 21) for lifting the stack of plates (14) to a desired height.

8. Apparatus as claimed in claim 7, wherein the lifting and transporting means is mounted in the plate magazine (3) above the plate trolley (2), and comprises
several suction lifters (23) for suction connecting the uppermost plate (14) of the stack,
a lifting device (25) for lifting the suction lifters (23) and the plate (14) connected thereto, and
means (26) for carrying and moving the plate (14) into a position above the original (13) on the original carrier (1) in the exposure chamber (4).

9. Apparatus as claimed in any one of claims 6 to 8 which includes a second original carrier arranged to operate alternately with the first-mentioned carrier whereby a first original on the first original carrier can be exposed in the exposure chamber (4) whilst the second original carrier is positioned outside said exposure chamber (4) to receive a second original.

10. Apparatus as claimed in any one of claims 6 to 9 for use with highly sensitive radiation sensitive plates, which additionally includes a light protected conveyor for transporting the exposed plate to the processing means which is also light protected, and wherein the exposure chamber includes an exposure light (33), for exposing the radiation sensitive plate, which is a point light.
